# EUROPEAN PATENT SPECIFICATION

(11) **EP 3 073 160 B1**
(45) Date of publication and mention of the grant of the patent: **28.02.2018**
(21) Application number: 14864251.5
(22) Date of filing: 19.11.2014
(51) Int. Cl.: F16J 15/40, B23B 19/02, F16C 19/06, F16C 19/54, F16C 33/76, F16C 35/12, H01L 21/67

(54) **ROTATION MECHANISM, MACHINE TOOL, AND SEMICONDUCTOR MANUFACTURING DEVICE**
DREHMECHANISMUS, WERKZEUGMASCHINE UND HALBLEITERHERSTELLUNGSVORRICHTUNG
MÉCANISME DE ROTATION, MACHINE-OUTIL, ET DISPOSITIF DE FABRICATION DE SEMI-CONDUCTEURS

(30) Priority: 20.11.2013 JP 2013240386; 14.01.2014 JP 2014004632; 28.01.2014 JP 2014013801; 13.02.2014 JP 2014025850; 07.03.2014 JP 2014045255
(43) Date of publication of application: 28.09.2016
(73) Proprietor: NSK Ltd., Tokyo 141-8560 (JP)
(72) Inventor: NAKAMURA, Tsuyoshi, Fujisawa-shi Kanagawa 251-8501 (JP)
(74) Representative: Schwabe - Sandmair - Marx
(86) International application number: PCT/JP2014/080689
(87) International publication number: WO 2015/076313

(56) References cited:
- JP-A- 2002 061 750
- JP-A- 2004 197 786
- JP-A- 2004 197 786
- JP-U- S63 169 253
- US-A1- 2003 178 785
- US-A1- 2010 050 942

## Description

### Field

The present invention relates to a rotating mechanism, a machine tool, and a semiconductor manufacturing device.

### Background

For a transporting device, a semiconductor manufacturing device, a machine tool or the like, a rotating mechanism is used which rotates a rotation stage, or rotates a tool or a workpiece. In such a rotating mechanism, a seal with a gas may be used for a rotating unit in order to prevent entry of a liquid or foreign material from the outside (for example, Patent Literature 1) .

### Citation List

### Patent Literature

Patent Literature 1: Japanese Patent Application Laid-open No. 9-150336
Patent Literature 2: Japanese Patent Application JP 2002 061750 A is disclosing a non contact sealing device, adapted to a processing chamber, that can prevent leakage of a lubricating oil of a bearing on a rotary shaft and an external fluid intrusion in said chamber, and can provide a continuously constant sealing effect via a simple structure.

### Summary

### Technical Problem

There is a rotating mechanism which rotates a shaft with rotating bodies attached to both sides of the shaft. The technique described in Patent Literature 1 is directed to a rotating mechanism in which a rotating body is attached to one end of a shaft. Therefore, there is room for improvement with respect to sealing of a rotating unit with a gas in a rotating mechanism which rotates a shaft with rotating bodies attached to both sides of the shaft.

An object of the present invention is to provide a rotating mechanism, a machine tool, and a semiconductor manufacturing device which are suitable for a device in which a shaft is rotated with rotating bodies attached to both sides thereof with a rotating portion sealed with a gas.

### Solution to Problem

According to the present invention, thete is provided a rotating mechanism comprising: a housing; a shaft that is inserted into a first hole and a second hole provided in the housing; a bearing that is provided in the housing and rotatably supports the shaft; a first rotating member that is provided on a first end portion of the shaft to rotate with the shaft, and includes a protruding portion that protrudes outside the first hole in a radial direction thereof and to a side portion of the housing, the protruding portion being opposed to the side portion of the housing with a first gap having a predetermined size therebetween; a second rotating member that is provided on a second end portion of the shaft to rotate with the shaft, protrudes outside the second hole in a radial direction thereof and is opposed to the housing on the side of the second end portion with a second gap having a predetermined size therebetween; a first opening that is open to the outside of the first hole of the housing in a radial direction thereof to be opposed to the first rotating member and extends along a circumferential direction of the first hole for supplying a gas to the first gap; and a second opening that is open to the outside of the second hole of the housing in a radial direction thereof to be opposed to the second rotating member and extends along a circumferential direction of the second hole for supplying a gas to the second gap.

In the rotating mechanism, a gas is supplied from a first opening to a first gap on a first rotating member side, and a gas is supplied from a second opening to a second gap on a second rotating member side. Since the gases flow outside a housing from the first gap and the second gap respectively, portions of the first rotating member and the second rotating member, which are rotating bodies, are sealed. Thus, the rotating mechanism is suitable for a device in which a shaft is rotated with rotating bodies attached to both sides thereof with a rotating portion sealed with a gas.

Preferably, the first rotating member is disposed above the second rotating member. The first gap is formed between a side portion of the housing and a protruding portion of the first rotating member. If the first gap on the first rotating member side is disposed above, a gas outlet is positioned below the first opening.
Consequently, by disposing the first rotating member provided with the first gap above the second rotating member, when the supply of the gas has stopped and a liquid has entered the first gap, the liquid is easily discharged from the first gap.

Preferably, a size of the first gap is larger than a dimension of the first opening in a radial direction of the shaft, and a size of the second gap is larger than a dimension of the second opening in the radial direction of the shaft. By setting the dimensions as described above, the gases can be uniformly released from the first opening and the second opening along the circumferential direction of the first rotating member and the second rotating member, respectively. In addition, since the size of the first gap is larger than the dimension of the first opening in the radial direction of the shaft, and the size of the second gap is larger than the dimension of the second opening in the radial direction of the shaft, the gases which have flowed out of the first opening and the second opening are respectively led to the first gap and the second gap without fail. Therefore, in the rotating mechanism, a portion including the first rotating member and a portion including the second rotating member can be sealed without fail.

Preferably, a portion between the first rotating member and the housing in a portion between the first hole and the first opening includes a portion whose size is smaller than a dimension of the first opening in a radial direction of the first hole, and a portion between the second rotating member and the housing in a portion between the second hole and the second opening includes a portion whose size is smaller than a dimension of the second opening in a radial direction of the second hole. By such configuration, the portion having a smaller dimension than the first opening and the portion having a smaller dimension than the second opening exhibit a sealing function. Accordingly, even when a liquid has entered the housing from each of the first gap and the second gap, the liquid is prevented from reaching a portion where the shaft is provided.

Preferably, the rotating mechanism comprises a groove along the circumferential direction of the first hole, in a portion of the housing adjacent to the first gap. By the structure described above, even when the central axis of rotation of the first rotating member and the second rotating member is tilted with respect to a direction in which the gravitational force is acting, a liquid stored in the first gap can be discharged outside the housing through the groove.

Preferably, the rotating mechanism comprises a groove along the circumferential direction of the second hole, in a portion of the second rotating member adjacent to the second gap. By the structure described above, even when the central axis of rotation of the first rotating member and the second rotating member is tilted with respect to a direction in which the gravitational force is acting, a liquid stored in the second gap can be discharged outside the housing through the groove.

Preferably, the gas is supplied to the first opening through a first throttle portion that is formed between two parts, extends in a direction perpendicular to a central axis of rotation of the shaft, and has a space smaller than that of the first opening, and the gas is supplied to the second opening through a second throttle portion that is formed between two parts, extends in a direction perpendicular to the central axis of rotation of the shaft, and has a space smaller than that of the second opening. By doing so, the number of accuracy control items for the two parts constituting the first throttle portion and the two parts constituting the second throttle portion may be reduced.

Preferably, a first spacer is provided between the two parts constituting the first throttle portion, and a second spacer is provided between the two parts constituting the second throttle portion. With the first spacer and the second spacer, the number of accuracy control items for the two parts constituting the first throttle portion and the two parts constituting the second throttle portion may be further reduced.

Since the machine tool according to the present invention includes the rotating mechanism described above, the machine tool is suitable for a device in which a shaft is rotated with rotating bodies attached to both sides thereof with a rotating portion sealed with a gas.

Since the semiconductor manufacturing device according to the present invention includes the rotating mechanism described above, the semiconductor manufacturing device is suitable for a device in which a shaft is rotated with rotating bodies attached to both sides thereof with a rotating portion sealed with a gas.

### Advantageous Effects of Invention

With the present invention, it is possible to provide a rotating mechanism, a machine tool, and a semiconductor manufacturing device which are suitable for a device in which a shaft is rotated with rotating bodies attached to both sides thereof with a rotating portion sealed with a gas.

### Brief Description of Drawings

FIG. 1 is a sectional view illustrating a rotating mechanism according to a first embodiment.
FIG. 2 is a sectional view illustrating a rotating mechanism according to a variation of the first embodiment.
FIG. 3 is a sectional view illustrating a rotating mechanism according to a second embodiment.
FIG. 4 is a sectional view illustrating a rotating mechanism according to a third embodiment.
FIG. 5 is a sectional view illustrating a rotating mechanism according to a variation of the third embodiment.
FIG. 6 is a sectional view illustrating a rotating mechanism according to a fourth embodiment.
FIG. 7 is a sectional view illustrating a rotating mechanism according to a fifth embodiment.
FIG. 8 is a sectional view illustrating a rotating mechanism according to a variation of the fifth embodiment.

### Description of Embodiments

### (First Embodiment)

Hereinafter, a mode for carrying out the present invention (hereinafter referred to as a first embodiment) is described with reference to the drawings.

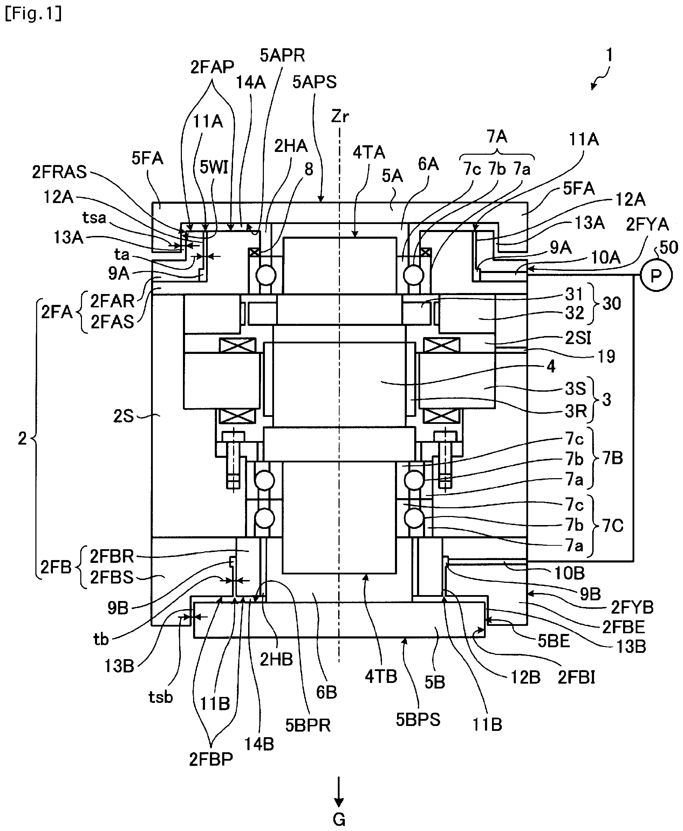

FIG. 1 is a sectional view illustrating a rotating mechanism according to the first embodiment. FIG. 1 illustrates a section of the rotating mechanism 1, cut along a plane which includes a central axis of rotation Zr of the rotating mechanism 1 and is parallel with the central axis of rotation Zr. The direction indicated by an arrow G in FIG. 1 is a direction in which the gravitational force is acting. The rotating mechanism 1 is a machine element which transmits rotation and is applied, for example, to a machine tool, a transporting device used in a special environment such as a vacuum chamber, a semiconductor manufacturing device, or a flat panel display manufacturing device. Here, a case where the rotating mechanism 1 is a spindle unit which includes a spindle as a rotation shaft is described as an example. However, the application of the rotating mechanism 1 is not limited thereto.

The rotating mechanism 1 includes a housing 2, a shaft 4, bearings 7A, 7B, and 7C, a first rotating member 5A as a rotating body, a second rotating member 5B as a rotating body, a first opening 11A, and a second opening 11B. The housing 2 is a member which accommodates the bearings 7A, 7B, and 7C, an electric motor 3, and the like. In the embodiment, the housing 2 includes a body portion 2S which is a cylindrical member, a first structure 2FA provided at one end portion of the body portion 2S, and a second structure 2FB provided at another end portion of the body portion 2S. Each of the body portion 2S, the first structure 2FA, and the second structure 2FB is a part of the housing 2. In the embodiment, the body portion 2S is a cylindrical member, and includes a through hole 2SI leading from one end portion to another end portion thereof, in other words, from the first structure 2FA to the second structure 2FB.

The first structure 2FA includes a first member 2FAS and a second member 2FAR, which are combined with each other. The second structure 2FB includes a first member 2FBS and a second member 2FBR, which are combined with each other. Both of the first structure 2FA and the second structure 2FB are plate-shaped members. In the embodiment, the first structure 2FA and the second structure 2FB have a circular shape in a plane view. However, the shapes thereof are not limited to a circular shape.

Both of the first member 2FAS and the second member 2FAR included in the first structure 2FA are annular members. The second member 2FAR is attached to the first member 2FAS from one end portion thereof, and provided on the outside of the first member 2FAS in the radial direction thereof. Both of the first member 2FBS and the second member 2FBR included in the second structure 2FB are annular members. The second member 2FBR is attached to the inside of the first member 2FBS in the radial direction thereof.

Between the first member 2FAS and the second member 2FAR of the first structure 2FA, in a radial direction of a first hole 2HA, a predetermined gap 12A is provided. The gap 12A is opened to a surface 2FAP of the first structure 2FA. The surface 2FAP is opposed to the first rotating member 5A. The opening is the first opening 11A. The first opening 11A is opposed to the first rotating member 5A. A groove 9A is provided in an inner circumferential surface of the second member 2FAR along a circumferential direction thereof. The groove 9A is connected to the gap 12A. The groove 9A is connected to a first gas passage 10A.

Between the first member 2FBS and the second member 2FBR of the second structure 2FB, in a radial direction of a second hole 2HB, a predetermined gap 12B is provided. The gap 12B is opened to a surface 2FBP of the second structure 2FB. The surface 2FBP is opposed to the second rotating member 5B. The opening is the second opening 11B. The second opening 11B is opposed to the second rotating member 5B. A groove 9B is provided in an inner circumferential surface of the second member 2FBR along a circumferential direction thereof. The groove 9B is connected to the gap 12B. The groove 9B is connected to a second gas passage 10B.

The first structure 2FA includes a first hole 2HA which includes the central axis of rotation Zr of the shaft 4 and penetrates in a thickness direction. The second structure 2FB includes a second hole 2HB which includes the central axis of rotation Zr of the shaft 4 and penetrates in a thickness direction. The shaft 4 is an output shaft of the rotating mechanism 1 and is inserted into the housing 2, more specifically, into both of the first hole 2HA in the first structure 2FA and the second hole 2HB in the second structure 2FB of the housing 2.

The bearing 7A is provided in the housing 2, in the embodiment, in an inner circumferential portion of the first member 2FAS of the first structure 2FA, via an annular preload member 8, and rotatably supports the shaft 4. The bearings 7B and 7C are provided in the housing 2, in the embodiment, in an inner circumferential portion of the body portion 2S, on the second rotating member 5B side thereof, and rotatably support the shaft 4. The bearings 7B and 7C are attached to the shaft 4, on a side of a second end portion 4TB. In the embodiment, the shaft 4 is supported by the housing 2 through the three bearings 7A, 7B, and 7C. However, the number of the bearings is not limited to three.

The bearings 7A, 7B, and 7C each include an outer ring 7a, a rolling element 7b, and an inner ring 7c. The inner ring 7c is disposed inside the outer ring 7a in the radial direction thereof. As described above, in the embodiment, all of the bearings 7A, 7B, and 7C are rolling bearings. The rolling element 7b is disposed between the outer ring 7a and the inner ring 7c. In the bearing 7A, the outer ring 7a is in contact with an inner wall of the first member 2FAS of the first structure 2FA in the housing 2. In the bearings 7B and 7C, the outer rings 7a are in contact with an inner wall of the through hole 2SI in the body portion 2S of the housing 2. By the structure described above, the bearings 7A, 7B, and 7C are attached to the housing 2. In the embodiment, the bearings 7A, 7B, and 7C are all ball bearings. However, the type of the bearings 7A, 7B, and 7C as a rolling bearing is not limited to the ball bearing. In addition, in the embodiment, the bearings 7A, 7B, and 7C are all rolling bearings. However, the bearings 7A, 7B, and 7C may be a sliding bearing, a hydrostatic bearing, or a magnetic bearing. The hydrostatic bearing may be realized, for example, by providing an exhaust groove in an inner circumferential surface of the first hole 2HA in the first member 2FAS of the first structure 2FA along a circumferential direction of the first hole 2HA, and by providing an exhaust groove in an inner circumferential surface of the second hole 2HB in the second member 2FBR of the second structure 2FB along a circumferential direction of the second hole 2HB.

The first rotating member 5A is provided on a first end portion 4TA of the shaft 4, and rotates with the shaft 4. In the embodiment, the first rotating member 5A is attached to the shaft 4 through a first supporting member 6A. The second rotating member 5B is attached to the shaft 4 through a second supporting member 6B. The second rotating member 5B is provided on the second end portion 4TB of the shaft 4, and rotates with the shaft 4. As described above, the first rotating member 5A and the second rotating member 5B rotate with the shaft 4.

The first rotating member 5A is opposed to the side portion of the first structure 2FA with a predetermined first gap 13A therebetween. In the embodiment, the first rotating member 5A has a protruding portion 5FA. The protruding portion 5FA is formed by an outer circumferential portion of the first rotating member 5A on the first structure 2FA side, which has extended to the side of the second member 2FAR of the first structure 2FA. The protruding portion 5FA and the second member 2FAR overlap in a direction of central axis of rotation Zr of the first rotating member 5A. The first gap 13A is a portion where a side portion 2FRAS of the second member 2FAR of the first structure 2FA and an inner circumferential portion 5WI of the protruding portion 5FA of the first rotating member 5A are opposed to each other in a portion where the protruding portion 5FA and the second member 2FAR overlap.

The second rotating member 5B is opposed to the housing 2 with a predetermined second gap 13B therebetween. In the embodiment, the first member 2FBS of the second structure 2FB in the housing 2 has a protruding portion 2FBE. The protruding portion 2FBE is formed by a side portion of the first member 2FBS on the second rotating member 5B side, which has extended to the second rotating member 5B side. The protruding portion 2FBE of the first member 2FBS and the second rotating member 5B overlap in a direction of central axis of rotation Zr of the second rotating member 5B. The second gap 13B is a portion where a side portion 5BE of the second rotating member 5B and an inner circumferential surface 2FBI of the protruding portion 2FBE of the first member 2FBS in the second structure 2FB are opposed to each other in a portion where the second rotating member 5B and the protruding portion 2FBE of the first member 2FBS overlap.

Regarding the first rotating member 5A, an object is placed on a surface 5APS which is on the side opposite to the first end portion 4TA of the shaft 4. In the embodiment, the first rotating member 5A is a plate-shaped member, and has a circular shape in a plane view. The first rotating member 5A protrudes outside the first hole 2HA in the radial direction thereof. The first hole 2HA is provided in the first structure 2FA of the housing 2. A portion which protrudes outside the first hole 2HA in the radial direction thereof is opposed, as illustrated in FIG. 1, to the housing 2 with a predetermined gap 14A therebetween. The gap 14A is formed between the surface 2FAP and a surface 5APR. The surface 2FAP is a surface of the first member 2FAS and the second member 2FAR of the housing 2, and is opposed to the first rotating member 5A. The surface 5APR is a surface of the first rotating member 5A and is opposed to the first structure 2FA.

Regarding the second rotating member 5B, an object is placed on a surface 5BPS which is on the side opposite to the second end portion 4TB of the shaft 4. In the embodiment, the second rotating member 5B is a plate-shaped member, and has a circular shape in a plane view. The second rotating member 5B protrudes outside the second hole 2HB in the radial direction thereof. The second hole 2HB is provided in the second structure 2FB of the housing 2. A portion which protrudes outside the second hole 2HB in the radial direction thereof is opposed, as illustrated in FIG. 1, to the housing 2 with a predetermined gap 14B therebetween. The gap 14B is formed between the surface 2FBP and a surface 5BPR. The surface 2FBP is a surface of the first member 2FBS and the second member 2FBR of the housing 2, and is opposed to the second rotating member 5B. The surface 5BPR is a surface of the second rotating member 5B and is opposed to the second structure 2FB.

The first gas passage 10A is provided in a portion of the housing 2, which portion is opposed to the first rotating member 5A, more specifically, in the second member 2FAR of the first structure 2FA of the housing 2. The first gas passage 10A is opened to a side portion 2FYA of the second member 2FAR of the first structure 2FA. The second gas passage 10B is provided in a portion of the housing 2, which portion is opposed to the second rotating member 5B, more specifically, in the first member 2FBS of the second structure 2FB of the housing 2. The second gas passage 10B is opened to a side portion 2FYB of the first member 2FBS of the second structure 2FB.

The first gas passage 10A and the second gas passage 10B are connected to an air supply device 50. The air supply device 50 supplies a gas (in the embodiment, air) to the groove 9A and the groove 9B through the first gas passage 10A and the second gas passage 10B, respectively. The air supply device 50 is, for example, a pump. A gas from the first gas passage 10A flows out from the first opening 11A to the gap 14A, and is supplied to the first gap 13A. A gas from the second gas passage 10B flows out from the second opening 11B to the gap 14B, and is supplied to the second gap 13B. The gases supplied to the first gap 13A and the second gap 13B flow out of the housing 2, whereby sealing of the inside and the outside of the housing 2 is performed.

In the embodiment, the rotating mechanism 1 includes one first gas passage 10A and one second gas passage 10B. However, the numbers thereof are not limited. In a case where the rotating mechanism 1 includes a plurality of the first gas passages 10A and a plurality of the second gas passages 10B, the first gas passages 10A and the second gas passages 10B are preferably provided around the central axis of rotation Zr at equal intervals.

In the housing 2, the electric motor 3 is provided. The electric motor 3 includes a rotor 3R and a stator 3S provided outside the rotor 3R in the radial direction thereof. The stator 3S is attached to the inner wall of the through hole 2SI in the body portion 2S. The rotor 3R is provided between the first end portion 4TA and the second end portion 4TB of the shaft 4. By the structure described above, the rotor 3R, the shaft 4, the first rotating member 5A, and the second rotating member 5B integrally rotate about the central axis of rotation Zr. In the embodiment, the type of the electric motor 3 is not limited.

In the embodiment, dust generated by the bearings 7A, 7B, and 7C is collected by gases passing through the first hole 2HA and the second hole 2HB. When the inside of the through hole 2SI is sealed, it is difficult for the gases to pass through the first hole 2HA and the second hole 2HB. For that reason, the through hole 2SI is protected from sealing. The body portion 2S of the housing 2 includes an exhaust passage 19 which connects the through hole 2SI and the outside, and discharges a gas in the through hole 2SI to the outside of the housing 2. A throttle valve is preferably provided in the exhaust passage 19. The throttle valve suppresses a flow rate of a gas passing through the exhaust passage 19. Therefore, an increase in a supply amount of a gas, which is supplied from each of the first gas passage 10A and the second gas passage 10B, is suppressed.

In the embodiment, as described above, gases which have flowed out of the first opening 11A and the second opening 11B are supplied to the first gap 13A and the second gap 13B, respectively, and then flow out of the housing 2. Consequently, entry of foreign materials from the outside of the rotating mechanism 1 to a gap between the shaft 4 and the housing 2, entry of foreign materials to the bearings 7A, 7B, and 7C, and outflow of dust generated in the housing 2 to the outside thereof, are suppressed. Examples of the dust generated in the housing 2 include dust generated in the bearings 7A, 7B, and 7C and dust generated in the electric motor 3.

When the exhaust passage 19 is narrow and/or long, a resistance to an exhaust gas increases. Therefore, it may become difficult to discharge a gas from the through hole 2SI. As a result, there may be a case where the gas in the through hole 2SI is entrained in the flow of the gases which have flowed out of the first opening 11A and the second opening 11B, so that the dust generated in the bearings 7A, 7B, and 7C is flowed out of the housing 2. In order to avoid the above case, the flow rate of the gas passing through the exhaust passage 19 may be secured by connecting an exhaust device to the exhaust passage 19, or connecting the exhaust passage 19 to a space whose pressure is reduced. By doing so, the possibility of outflow of the dust generated in the bearings 7A, 7B, and 7C to the outside of the housing 2 can be decreased.

For the rotating mechanism 1, a mechanical bearing which does not need a gas supply such as a rolling bearing and a sliding bearing can be used as the bearings 7A, 7B, and 7C. With the use of a rolling bearing as the bearings 7A, 7B, and 7C, displacement of the shaft 4 in directions of the gaps 14A and 14B is suppressed, provided that the displacement results from a factor other than loads of objects mounted on the first rotating member 5A and the second rotating member 5B.

In the embodiment, a size tsa of the first gap 13A is larger than a width ta of the first opening 11A, in other words, larger than a dimension of the first opening 11A in the radial direction of the first hole 2HA. The width ta of the first opening 11A is equal to a width of the gap 12A. A size tsb of the second gap 13B is larger than a width tb of the second opening 11B, in other words, larger than a dimension of the second opening 11B in the radial direction of the second hole 2HB. The width tb of the second opening 11B is equal to a width of the gap 12B. By setting the size tsa of the first gap 13A to be larger than the width ta of the first opening 11A, and the size tsb of the second gap 13B to be larger than the width tb of the second opening 11B, as described above, a gas which has flowed out of the first opening 11A can be efficiently directed to the first gap 13A, and a gas which has flowed out of the second opening 11B can be efficiently directed to the second gap 13B, whereby a sealing effect can be exerted without fail.

For example, a slot throttle of a gas bearing can be used for the first opening 11A and the second opening 11B. The width ta of the first opening 11A and the width tb of the second opening 11B are, for example, about several to several tens of micrometers. The size tsa of the first gap 13A and the size tsb of the second gap 13B vary depending on the sizes of the width ta of the first opening 11A and the width tb of the second opening 11B. For the first opening 11A and the second opening 11B, various throttling types for hydrostatic bearings, for example, a porous media type or a restricted nozzle type, can be used.

The first opening 11A and the second opening 11B are formed along circumferential directions of the first hole 2HA and the second hole 2HB, respectively. Accordingly, the first opening 11A can uniformly eject a gas between the first rotating member 5A and the first structure 2FA in a circumferential direction thereof, and the second opening 11B can uniformly eject a gas between the second rotating member 5B and the second structure 2FB in a circumferential direction thereof. In a case where it is desirable to increase the width ta of the first opening 11A and the width tb of the second opening 11B in order to eject a gas uniformly, an adjustment device, which is for suppressing a flow rate of a gas flowing into each of the gap 12A and the gap 12B, can be provided in the first gas passage 10A and the second gas passage 10B, or a passage connected thereto.

The first opening 11A and the gap 12A are formed between the first member 2FAS and the second member 2FAR of the first structure 2FA. In other words, the first opening 11A and the gap 12A are formed between two members. The second opening 11B and the gap 12B are formed between the first member 2FBS and the second member 2FBR of the second structure 2FB. In other words, the first opening 11A and the gap 12A, as well as the second opening 11B and the gap 12B are formed between two members. As described above, the first opening 11A and the second opening 11B do not let a gas flow out of the gap between the rotating body and the housing. Accordingly, regarding the first member 2FAS and the second member 2FAR of the first structure 2FA, and the first member 2FBS and the second member 2FBR of the second structure 2FB, control of dimension accuracy thereof, and a geometric tolerance such as cylindricity can be alleviated. As a result, production cost of the first structure 2FA and the second structure 2FB can be reduced. In addition, by forming the first opening 11A and the gap 12A, and the second opening 11B and the gap 12B by connecting two members through fitting, the dimensions thereof are relatively easily controlled. Furthermore, by forming the first structure 2FA and the second structure 2FB with two members, parts thereof are easily replaced.

In addition, a material can be adopted which is excellent from the viewpoint of corrosion resistance to the atmosphere outside the housing 2 to be sealed but cannot be adopted from the viewpoint of processability. For example, a material excellent in corrosion resistance which has not been adopted can be adopted, in the first structure 2FA, to the second member 2FAR provided on the outside of the housing 2, or to the first member 2FBS of the second structure 2FB.

The first gap 13A which exerts a sealing function is a portion where the protruding portion 5FA of the first rotating member 5A and the second member 2FAR of the first structure 2FA overlap. The second gap 13B which exerts a sealing function is a portion where the side portion 5BE of the second rotating member 5B and the inner circumferential surface 2FBI of the protruding portion 2FBE of the first member 2FBS in the second structure 2FB overlap. The gap 12A reduces a supply amount of a gas from the first opening 11A, and the gap 12B reduces a supply amount of a gas from the second opening 11B.

Even in a case where supply of a gas from the air supply device 50 has stopped, the rotating mechanism 1 can suppress entry of a liquid or the like by the first gap 13A and the second gap 13B. The same is true in a case where a liquid or the like is sprayed from the outside of the housing 2 to the first rotating member 5A and the second rotating member 5B.

In the embodiment, the first rotating member 5A provided with the first gap 13A is disposed above the second rotating member 5B provided with the second gap 13B. In other words, the first rotating member 5A is disposed on the side opposite to the direction in which the gravitational force is acting, and the second rotating member 5B is disposed on the side of the direction in which the gravitational force is acting. By doing so, in a case where a liquid or the like has flowed into the first gap 13A on the first rotating member 5A side, the liquid is easily discharged by the action of gravity from the lower side of the first gap 13A (the side of the direction in which the gravitational force is acting). In addition, regarding the second gap 13B on the second rotating member 5B side, the surface 5BPS of the second rotating member 5B, which is a surface opposed to the second end portion 4TB of the shaft 4, faces downward. Accordingly, in a case where a liquid or the like has flowed into the second gap 13B, the liquid is easily discharged by the action of gravity from the second gap 13B. Furthermore, even in a case where supply of a gas from the air supply device 50 has stopped, entry of a liquid or the like can be suppressed.

### (Variation)

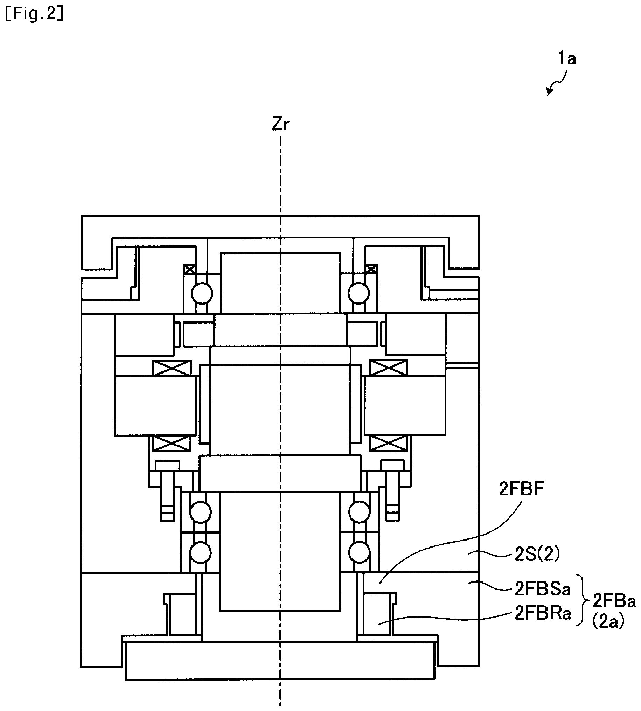

FIG. 2 is a sectional view illustrating a rotating mechanism according to a variation of the first embodiment. FIG. 2 illustrates a section of a rotating mechanism 1a, cut along a plane which includes a central axis of rotation Zr of the rotating mechanism 1a and is parallel with the central axis of rotation Zr. As illustrated in FIG. 1, in the rotating mechanism 1 of the first embodiment, the second member 2FBR of the second structure 2FB is in contact with the end portion of the body portion 2S of the housing 2. The rotating mechanism 1a of the variation is different therefrom in that a second member 2FBRa of a second structure 2FBa is not in contact with an end portion of a body portion 2S of a housing 2a. Therefore, a first member 2FBSa of the second structure 2FBa has a protruding portion 2FBF formed by a portion in contact with the body portion 2S and protruding inward in the radial direction of the first member 2FBSa. The second member 2FBRa of the second structure 2FBa is in contact with the body portion 2S of the housing 2a through the protruding portion 2FBF. Even in the structure described above, the rotating mechanism 1a achieves the same action and effect as those of the rotating mechanism 1. In addition, in the rotating mechanism 1a, the second member 2FBRa of the second structure 2FBa can be positioned in a direction of central axis of rotation Zr with the protruding portion 2FBF.

As described above, the rotating mechanisms 1 and 1a of the first embodiment and the variation thereof, respectively, are suitable for a device in which the shaft 4 is rotated with rotating bodies attached to both sides thereof with the rotating portion sealed with a gas. The configurations of the first embodiment and the variation thereof can be appropriately applied to the following embodiments. In that case, only a part of the configurations of the first embodiment and the variation thereof may be applied, or whole thereof may be applied.

### (Second Embodiment)

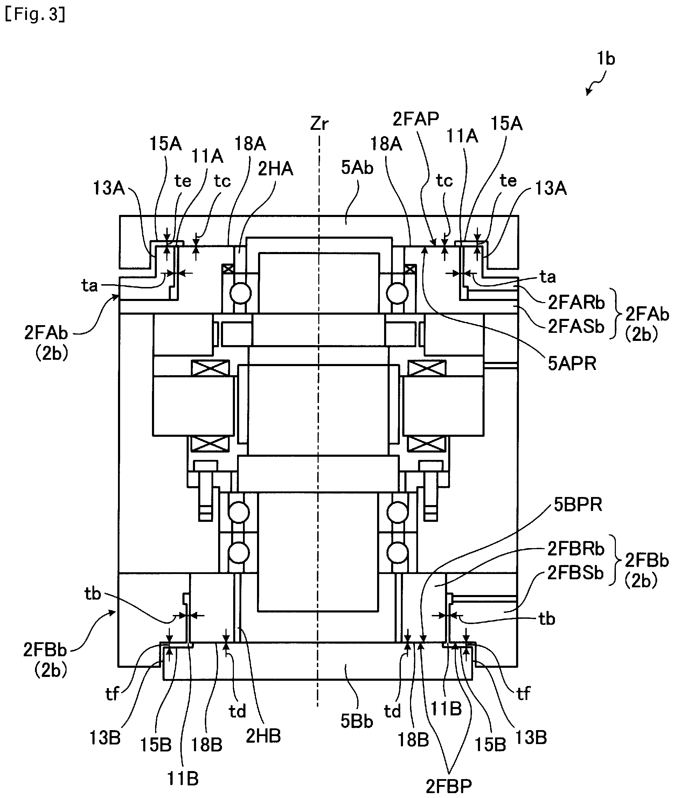

FIG. 3 is a sectional view illustrating a rotating mechanism according to a second embodiment. FIG. 3 illustrates a section of a rotating mechanism 1b, cut along a plane which includes a central axis of rotation Zr of the rotating mechanism 1b and is parallel with the central axis of rotation Zr. In the rotating mechanism 1b, a portion between a first rotating member 5Ab and a housing 2b in a portion between a first hole 2HA and a first opening 11A includes a portion 18A (hereinafter appropriately referred to as small gap portion 18A) whose size is smaller than the dimension of the first opening 11A in the radial direction of the first hole 2HA, in other words, the width ta. In addition, a portion between a second rotating member 5Bb and a housing 2b in a portion between a second hole 2HB and a second opening 11B includes a portion (hereinafter appropriately referred to as small gap portion 18B) whose size is smaller than the dimension of the second opening 11B in the radial direction of the second hole 2HB, in other words, the width tb.

The small gap portion 18A on a first structure 2FAb side is a gap between a first member 2FASb of the first structure 2FAb and the first rotating member 5Ab. The size of the small gap portion 18A, in other words, an interval between a surface 2FAP of the first member 2FASb and a surface 5APR of the first rotating member 5Ab is tc. The small gap portion 18B on a second structure 2FBb side is a gap between a second member 2FBRb of the second structure 2FBb and the second rotating member 5Bb. The size of the small gap portion 18B, in other words, an interval between a surface 2FBP of the second member 2FBRb and a surface 5BPR of the second rotating member 5Bb is td.

The rotating mechanism 1b includes, between the small gap portion 18A and the first opening 11A on the side of the first structure 2FAb, a large gap portion 15A which has a larger gap than the small gap portion 18A. The size of the large gap portion 15A is te. The large gap portion 15A is connected to a first gap 13A. The rotating mechanism 1b includes, between the small gap portion 18B and the second opening 11B on the side of the second structure 2FBb, a large gap portion 15B which has a larger gap than the small gap portion 18B. The size of the large gap portion 15B is tf. The large gap portion 15B is connected to a second gap 13B.

On the first rotating member 5Ab side, a relationship among the size te of the large gap portion 15A, the width ta of the first opening 11A, and the size tc of the small gap portion 18A is expressed by te > ta > tc. On the second rotating member 5Bb side, a relationship among the size tf of the large gap portion 15B, the width tb of the second opening 11B, and the size td of the small gap portion 18B is expressed by tf > tb > td.

As described above, the width ta of the first opening 11A and the width tb of the second opening 11B are several to several tens of micrometers. The size tc of the small gap portion 18A and the size td of the small gap portion 18B are about several micrometers to 20 micrometers, and the size te of the large gap portion 15A and the size tf of the large gap portion 15B are larger than several tens of micrometers.

A gas which has flowed out from the first opening 11A to the large gap portion 15A is supplied to the first gap 13A to seal the portion. A gas which has flowed out from the second opening 11B to the large gap portion 15B is supplied to the second gap 13B to seal the portion. In the rotating mechanism 1b, there may be a case where a liquid is accumulated, for example, due to abnormality in an external environment of the housing 2b, between the first rotating member 5Ab and the first structure 2FAb, or between the second rotating member 5Bb and the second structure 2FBb.

In the rotating mechanism 1b, the small gap portion 18A and the small gap portion 18B exert a sealing function. Accordingly, even in a case where a liquid has entered from the first gap 13A to the large gap portion 15A, and from the second gap 13B to the large gap portion 15B, it is possible to prevent the liquid from reaching the portion where a shaft 4 is provided. In particular, even in a case where supply of a gas to the first opening 11A and the second opening 11B has stopped, entry of the liquid into the portion where the shaft 4 is provided can be effectively suppressed, which is preferable.

As described above, the rotating mechanism 1b of the second embodiment is suitable for a device in which the shaft 4 is rotated with rotating bodies attached to both sides thereof with the rotating portion sealed with a gas. The configuration of the second embodiment can be appropriately applied to the following embodiments. In that case, only a part of the configuration of the second embodiment may be applied, or whole thereof may be applied.

### (Third Embodiment)

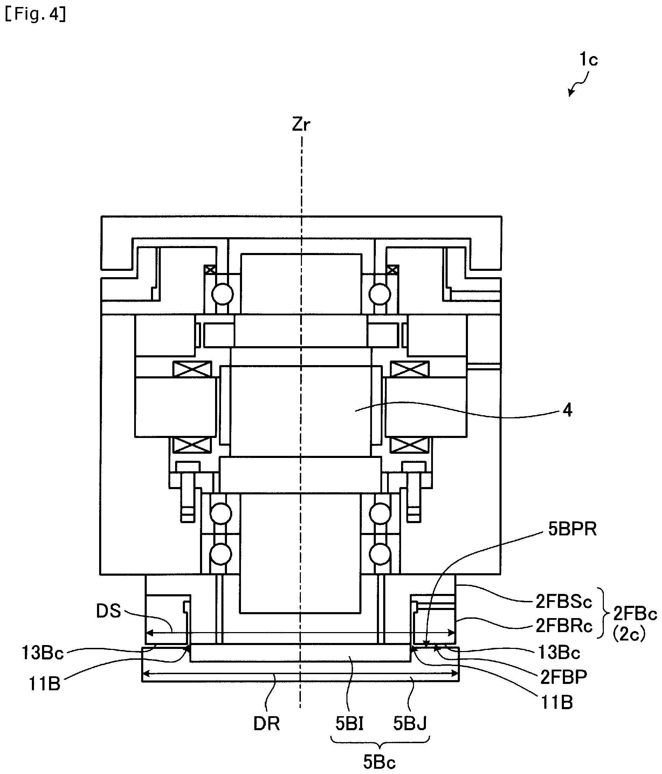

FIG. 4 is a sectional view illustrating a rotating mechanism according to a third embodiment. FIG. 4 illustrates a section of a rotating mechanism 1c, cut along a plane which includes a central axis of rotation Zr of the rotating mechanism 1c and is parallel with the central axis of rotation Zr. The rotating mechanism 1, the rotating mechanism 1b and the like described above have the second gap 13B which extends in a direction parallel with the central axis of rotation Zr. The rotating mechanism 1c of the third embodiment has a second gap 13Bc between a surface 5BPR of a second rotating member 5Bc and a surface 2FBP of a second structure 2FBc of a housing 2c. In other words, the rotating mechanism 1c is different from the rotating mechanisms described above in that the rotating mechanism 1c has the second gap 13Bc which extends in a direction intersecting (in this example, perpendicular to) the central axis of rotation Zr.

For example, a first member 2FBSc needs to have a high strength. A second member 2FBRc needs to have corrosion resistance or the like since it is very likely that the second member 2FBRc comes into contact with a liquid. By extending the second gap 13Bc in a direction intersecting (in this example, perpendicular to) the central axis of rotation Zr, it is possible to use, for each of the first member 2FBSc and the second member 2FBRc of the second structure 2FBc, a material which has a property necessary for each thereof. In this example, a high-strength material can be used for the first member 2FBSc and a material with a high corrosion resistance can be used for the second member 2FBRc. As a result, performance of the second structure 2FBc is improved.

In the embodiment, the second rotating member 5Bc includes a member 5BI and a member 5BJ. The member 5BI is attached to a shaft 4 and the member 5BJ is attached to the outside of the member 5BI. A second opening 11B is provided at a position opposed to the member 5BJ. The member 5BI attached to the shaft 4 does not directly contact the external environment of the rotating mechanism 1c since the member 5BJ is attached to the outside of the member 5BI. The member 5BJ needs to have corrosion resistance since the member 5BJ directly contacts the external environment of the rotating mechanism 1c. The member 5BI needs to have a strength since a rotational force from the shaft 4 is transmitted thereto.

The second rotating member 5Bc is formed of the two members 5BI and 5BJ. Consequently, a material which has a property suitable for each of the members 5BI and 5BJ can be used. In this example, a high-strength material can be used for the member 5BI and a material with a high corrosion resistance can be used for the member 5BJ. As a result, performance of the second rotating member 5Bc is improved. A diameter DR of the second rotating member 5Bc is larger than a diameter DS of the second structure 2FBc. However, the sizes of both diameters are not limited thereto. In addition, in the embodiment, the second gap 13Bc is extended in a direction intersecting the central axis of rotation Zr. However, the first gap 13A illustrated in FIG. 1 may be extended in a direction intersecting (for example, perpendicular to) the central axis of rotation Zr.

### (Variation)

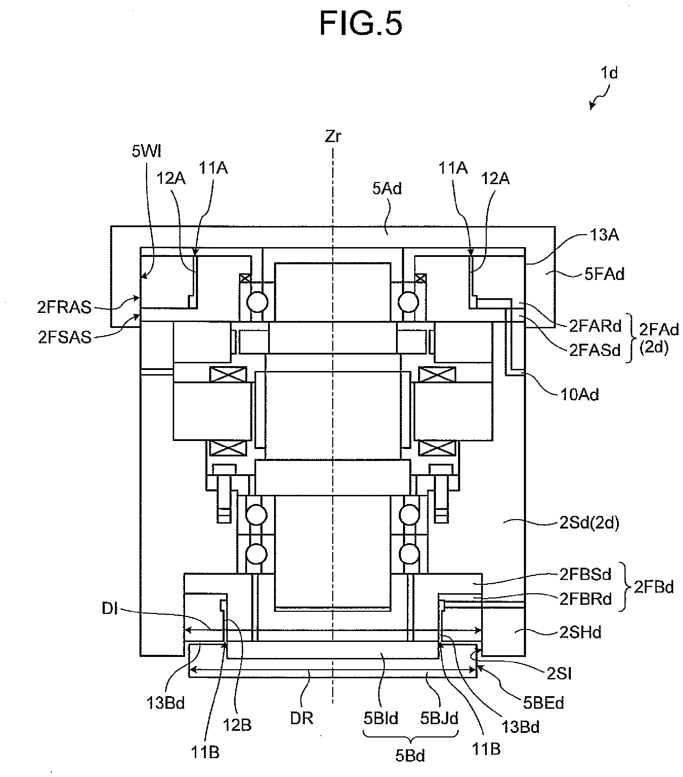

FIG. 5 is a sectional view illustrating a rotating mechanism according to a variation of the third embodiment. FIG. 5 illustrates a section of a rotating mechanism 1d, cut along a plane which includes a central axis of rotation Zr of the rotating mechanism 1d and is parallel with the central axis of rotation Zr. In the rotating mechanism 1d, a protruding portion 5FAd of a first rotating member 5Ad is extended to a body portion 2Sd of a housing 2d. By the structure described above, a first gap 13A is formed between an inner circumferential portion 5WI of the protruding portion 5FAd, and a side portion 2FSAS of a first member 2FASd and a side portion 2FRAS of a second member 2FARd of a first structure 2FAd.

An end portion of the body portion 2Sd of the housing 2d on the side of a second rotating member 5Bd has a protruding portion 2SHd which protrudes to a position of the second rotating member 5Bd. To an inner circumferential portion 2SI of the protruding portion 2SHd, a first member 2FBSd and a second member 2FBRd of a second structure 2FBd are attached. A diameter DR of the second rotating member 5Bd is smaller than an inner diameter DI of the protruding portion 2SHd. Consequently, a side portion 5BEd of the second rotating member 5Bd is opposed to the inner circumferential portion 2SI of the protruding portion 2SHd. A second gap 13Bd is formed between the second rotating member 5Bd and the second member 2FBRd of the second structure 2FBd. A diameter DR of the second rotating member 5Bd is smaller than an inner diameter DI of the protruding portion 2SHd.

By the structure described above, the degree of freedom can be increased for selecting a material of parts with which a first opening 11A and a gap 12A connected thereto, and a second opening 11B and a gap 12B connected thereto are formed. The parts described above are the first member 2FASd and a second member 2FARd of the first structure 2FAd, and the first member 2FBSd and the second member 2FBRd of the second structure 2FBd.

As described above, the rotating mechanisms 1c and 1d of the third embodiment and the variation thereof, respectively, are suitable for a device in which the shaft 4 is rotated with rotating bodies attached to both sides thereof with the rotating portion sealed with a gas. The configurations of the third embodiment and the variation thereof which have been described above can be appropriately applied to the following embodiments. In that case, only a part of the configurations of the third embodiment and the variation thereof may be applied, or whole thereof may be applied.

### (Fourth Embodiment)

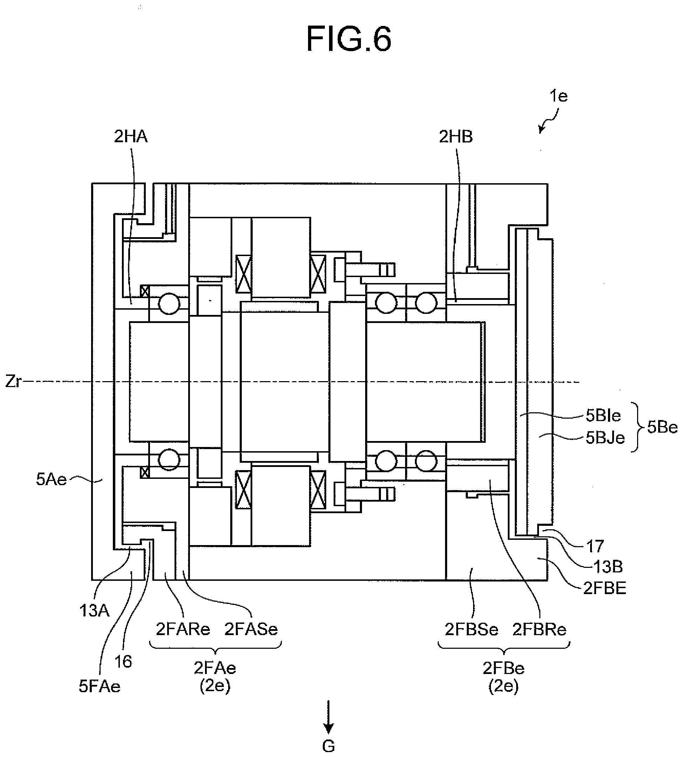

FIG. 6 is a sectional view illustrating a rotating mechanism according to a fourth embodiment. FIG. 6 illustrates a section of a rotating mechanism 1e, cut along a plane which includes a central axis of rotation Zr of the rotating mechanism 1e and is parallel with the central axis of rotation Zr. The rotating mechanism 1e of the fourth embodiment is different from the rotating mechanism 1 of the first embodiment described above in that the rotating mechanism 1e includes, in a portion of a housing 2e adjacent to a first gap 13A, a groove 16 along a circumferential direction of a first hole 2HA, and includes, in a portion of a second rotating member 5Be adjacent to a second gap 13B, a groove 17 along a circumferential direction of a second hole 2HB. The groove 16 extends to a position of a protruding portion 5FAe of a first rotating member 5Ae in a direction of central axis of rotation Zr. In the embodiment, the second rotating member 5Be is formed of two members, i.e. a member 5BIe and a member 5BJe. However, the second rotating member 5Be may be one member.

In the first to third embodiments, all of the rotating mechanisms 1, 1b, 1c, and 1d are provided such that the central axis of rotation Zr is parallel with a direction in which the gravitational force is acting. In the embodiment, the rotating mechanism 1e is provided such that the central axis of rotation Zr is intersecting (in the embodiment, perpendicular to) a direction in which the gravitational force is acting. If a liquid is present in an external atmosphere of the housing 2e, the liquid may be stored in the first gap 13A and the second gap 13B. Therefore, the rotating mechanism 1e includes the groove 16 in a portion of the housing 2e adjacent to the first gap 13A, which is a second member 2FARe in a first structure 2FAe in the embodiment. In addition, the rotating mechanism 1e includes the groove 17 in a portion of the second rotating member 5Be adjacent to the second gap 13B, which is a portion opposed to a first member 2FBSe in a second structure 2FBe in the embodiment.

The groove 16 discharges a liquid stored in the first gap 13A to the outside of the housing 2e. The groove 17 discharges a liquid stored in the second gap 13B to the outside of the housing 2e. As a result, storage of a liquid in the first gap 13A and the second gap 13B can be suppressed. The rotating mechanism 1e of the fourth embodiment is suitable for a device in which a shaft 4 is rotated with rotating bodies attached to both sides thereof with the rotating portion sealed with a gas. In particular, the rotating mechanism 1e is preferable in a case where the central axis of rotation Zr intersects a direction in which the gravitational force is acting. The configuration of the fourth embodiment which has been described above can be appropriately applied to the following embodiment. In that case, only a part of the configuration of the fourth embodiment may be applied, or whole thereof may be applied.

### (Fifth Embodiment)

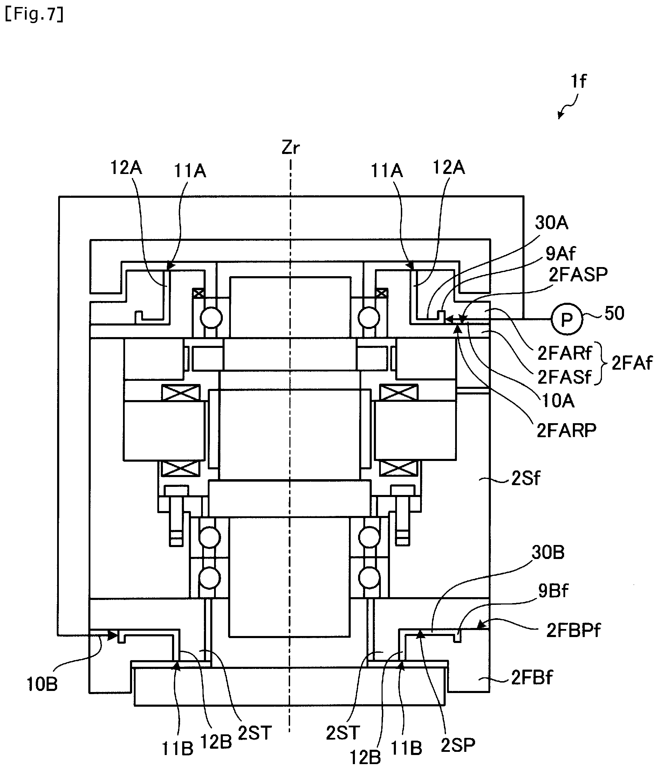

FIG. 7 is a sectional view illustrating a rotating mechanism according to a fifth embodiment. FIG. 7 illustrates a section of a rotating mechanism 1f, cut along a plane which includes a central axis of rotation Zr of the rotating mechanism 1f and is parallel with the central axis of rotation Zr. In the rotating mechanism 1f of the fifth embodiment, a first member 2FARf and a second member 2FASf in a first structure 2FAf are in contact with each other at each outer circumferential portion thereof. The first member 2FARf includes, on the outside in the radial direction thereof, an annular groove 9Af which extends along a circumferential direction. Regarding the first member 2FARf and the second member 2FASf, a surface 2FARP of the first member 2FARf and a surface 2FASP of the second member 2FASf are in contact with each other at the outside of the groove 9Af in the radial direction thereof.

A first throttle portion 30A is formed between the first member 2FARf and the second member 2FASf. The first throttle portion 30A is formed between two parts, in other words, the first member 2FARf and the second member 2FASf, and extends in a direction perpendicular to the central axis of rotation Zr of the rotating mechanism 1f. In order to form the first throttle portion 30A, the first member 2FARf includes a step difference between a portion of the surface 2FARP and a portion located inside the surface 2FARP in the radial direction of the first member 2FARf. The first throttle portion 30A is connected to a gap 12A at the inside of the first structure 2FAf in the radial direction thereof, and is connected to the groove 9Af at the inside of the first structure 2FAf in the radial direction thereof. The groove 9Af is connected to a first gas passage 10A. By the structure described above, a gas supplied from an air supply device 50 flows into the first throttle portion 30A via the first gas passage 10A and the groove 9Af. The gas which has flowed into the first throttle portion 30A flows out of a first opening 11A via the gap 12A. A space of the first throttle portion 30A is about several to several tens of micrometers, and is smaller than a space of the gap 12A.

The rotating mechanism 1f includes a protruding portion 2ST on an end portion of a body portion 2Sf on the side to which a second structure 2FBf is attached. The protruding portion 2ST is formed while partially protruding in a direction of the central axis of rotation Zr. The second structure 2FBf is attached to the outside of the protruding portion 2ST. A part of a surface 2FBPf of the second structure 2FBf and a part of an end surface 2SP of the body portion 2Sf on the side to which the second structure 2FBf is attached are in contact with each other on the outside in the radial direction of each thereof. A second throttle portion 30B is formed between the end surface 2SP and the second structure 2FBf. The second throttle portion 30B is formed between the body portion **2Sf** and the second structure 2FBf, and extends in a direction perpendicular to the central axis of rotation Zr of the rotating mechanism 1f. In order to form the second throttle portion 30B, the second structure 2FBf includes a step difference between a portion of the surface 2FBPf and a portion located inside the surface 2FBPf in the radial direction of the second structure 2FBf. A space of the second throttle portion 30B is about several to several tens of micrometers, and is smaller than a space of the gap 12B.

The second structure 2FBf includes, on the outside in the radial direction thereof, an annular groove 9Bf which extends along a circumferential direction. The second throttle portion 30B is connected to a gap 12B at the inside of the second structure 2FBf in the radial direction thereof, and is connected to the groove 9Bf at the inside of the second structure 2FBf in the radial direction thereof. The groove 9Bf is connected to a second gas passage 10B. By the structure described above, a gas supplied from the air supply device 50 flows into the second throttle portion 30B via the second gas passage 10B and the groove 9Bf. The gas which has flowed into the second throttle portion 30B flows out of a second opening 11B via the gap 12B.

In the rotating mechanism 1f, in order to form the first throttle portion 30A, the first member 2FARf only requires the flatness of the surface 2FARP and the step difference, and the second member 2FASf only requires the flatness of the surface 2FASP. The second structure 2FBf only requires, in order to form the second throttle portion 30B, the flatness of the surface 2FBPf and the step difference. Consequently, there is no need to control diameter tolerances of the first member 2FARf, the second member 2FASf, and the second structure 2FBf in the rotating mechanism 1f. Accordingly, the number of accuracy control items for the parts may be reduced, which is advantageous. As a result, yield is improved.

### (Variation)

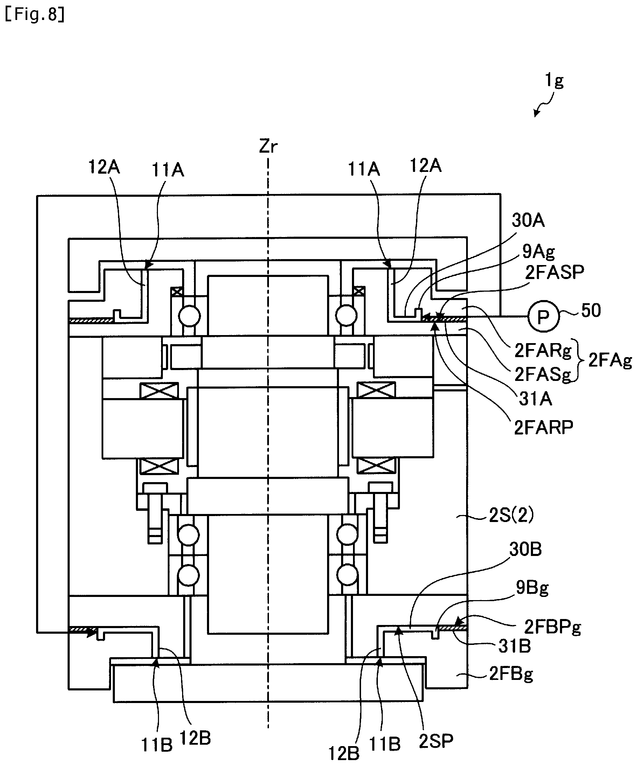

FIG. 8 is a sectional view illustrating a rotating mechanism according to a variation of the fifth embodiment. FIG. 8 illustrates a section of a rotating mechanism 1g, cut along a plane which includes a central axis of rotation Zr of the rotating mechanism 1g and is parallel with the central axis of rotation Zr. The rotating mechanism 1g in the variation is different from the rotating mechanism 1f of the fifth embodiment in that a first spacer 31A and a second spacer 31B are provided between the first member 2FARf and the second member 2FASf, and between the body portion 2Sf and the second structure 2FBf of the rotating mechanism 1f of the fifth embodiment, respectively. In the rotating mechanism 1g, a first throttle portion 30A and a second throttle portion 30B are formed with the thickness of the first spacer 31A and that of the second spacer 31B, respectively. In the rotating mechanism 1g, sizes of the first throttle portion 30A and the second throttle portion 30B can be changed, for example, by changing the thicknesses of the first spacer 31A and the second spacer 31B, respectively, depending on intended use.

In the rotating mechanism 1g, in order to form the first throttle portion 30A and the second throttle portion 30B with the first spacer 31A and the second spacer 31B, respectively, a first member 2FARg only requires the flatness of a surface 2FARP, and a second member 2FASg only requires the flatness of a surface 2FASP. A second structure 2FBg only requires, in order to form the second throttle portion 30B, the flatness of a surface 2FBPg. Consequently, there is no need to control diameter tolerances of the first member 2FARg, the second member 2FASg, and the second structure 2FBg in the rotating mechanism 1g. Accordingly, the number of accuracy control items for the parts may be further reduced, which is advantageous. As a result, yield is further improved.

The first to fifth embodiments have been described above. However, the first to fifth embodiments are not limited by the above description. In addition, the above-described components include those easily arrived at by a person skilled in the art, those substantially the same, and those included in so-called equivalents. Furthermore, the above-described components can be appropriately combined. Furthermore, at least one of various omissions, substitutions, and changes of the components can be performed without departing from the scope of the first to fifth embodiments.

### Reference Signs List

1, 1a, 1b, 1c, 1d, 1e Rotating mechanism
2, 2a, 2b, 2c, 2d, 2e Housing
2SI Through hole
2HA First hole
2HB Second hole
2FA, 2FAb, 2FAd, 2FAe First structure
2FB, 2FBa, 2FBb, 2FBc, 2FBd, 2FBd Second structure
2FAP, 2FBP Surface
2FAS, 2FASb, 2FASd, 2FBS, 2FBSa, 2FBSc, 2FBSd, 2FBSe First member
2FAR, 2FARd, 2FBR, 2FBRa, 2FBRb, 2FBRc, 2FBRd, 2FBRe Second member
2FRAS, 2FSAS, 2FYA, 2FYB Side portion
2FBE, 2FBF Protruding portion
2FBI Inner circumferential surface
2S, 2Sd Body portion
2SI Inner circumferential portion
2SHd Protruding portion
3 Electric motor
4 Shaft
4TA First end portion
4TB Second end portion
5A, 5Ab, 5Ac, 5Ad First rotating member
5B, 5Bb, 5Bc, 5Bd, 5Be Second rotating member
5BE, 5BEd Side portion
5FA, 5FAd Protruding portion
5WI Inner circumferential portion
5BJ, 5BJe, 5BI, 5BIe Member
5APS, 5APR, 5BPS, 5BPR Surface
6A First supporting member
6B Second supporting member
7A, 7B, 7C Bearing
8 Preload member
9A, 9B Groove
10A First gas passage
10B Second gas passage
11A First opening
11B Second opening
12A, 12B, 14A, 14B Gap
13A First gap
13B, 13Bc, 13Bd Second gap
15A, 15B Portion (large gap portion)
16, 17 Groove
18A, 18B Portion (small gap portion)
50 Air supply device
Zr Central axis of rotation

## Claims

1. A rotating mechanism (1) comprising:
a housing (2);
a shaft (4) that is inserted into a first hole (2HA) and a second hole (2HB) provided in the housing (2);
a bearing (7A, 7B, 7C) that is provided in the housing (2) and rotatably supports the shaft (4);
a first rotating member (5A) that is provided on a first end portion (4TA) of the shaft (4) to rotate with the shaft (4), and includes a protruding portion (5FA) that protrudes outside the first hole (2HA) in a radial direction thereof and to a side portion of the housing (2), an inner circumferential surface (5WI) of the protruding portion (5FA) being opposed to an outer circumferential surface of the side portion (2FRAS) of the housing (2) with a first gap (13A) having a predetermined size (tsa) therebetween;
a second rotating member (5B) that is provided on a second end portion (4TB) of the shaft (4) to rotate with the shaft (4), protrudes outside the second hole (2HB) in a radial direction thereof and is opposed to the housing (2) on the side of the second end portion (4TB) with a second gap (13B) having a predetermined size (tsb) therebetween;
a first opening (11A) that is open to the outside of the first hole (2HA) of the housing (2) in a radial direction thereof to be opposed to the first rotating member (5A) and extends along a circumferential direction of the first hole (2HA) for supplying a gas to the first gap (13A); and
a second opening (11B) that is open to the outside of the second hole (2HB) of the housing (2) in a radial direction thereof to be opposed to the second rotating member (5B) and extends along a circumferential direction of the second hole (2HB) for supplying a gas to the second gap (13B).

2. The rotating mechanism (1) according to claim 1, wherein the first rotating member (5A) is disposed above the second rotating member (5B).

3. The rotating mechanism (1) according to claim 1 or 2, wherein a size of the first gap (13A) is larger than a dimension of the first opening (11A) in a radial direction of the shaft (4), and a size of the second gap (13B) is larger than a dimension of the second opening (11B) in the radial direction of the shaft (4).

4. The rotating mechanism (1) according to any one of claims 1 to 3, wherein a portion between the first rotating member (5Ab) and the housing (2b) in a portion between the first hole (2HA) and the first opening (11A) includes a portion whose size (tc) is smaller than a dimension (ta) of the first opening (11A) in a radial direction of the first hole (2HA), and a portion between the second rotating member (5Bb) and the housing (2b) in a portion between the second hole (2HB) and the second opening (11B) includes a portion whose size (td) is smaller than a dimension (tb) of the second opening (11B) in a radial direction of the second hole (2HB).

5. The rotating mechanism (1) according to any one of claims 1 to 4, comprising a groove (16) along the circumferential direction of the first hole (2HA), in a portion of the housing (2) adjacent to the first gap (13A).

6. The rotating mechanism (1) according to any one of claims 1 to 5, comprising a groove (17) along the circumferential direction of the second hole (2HB), in a portion of the second rotating member (5Be) adjacent to the second gap (13B).

7. The rotating mechanism (1) according to any one of claims 1 to 6, wherein
the gas is supplied to the first opening (13A) through a first throttle portion (30A) that is formed between two parts, extends in a direction perpendicular to a central axis (Zr) of rotation of the shaft (4), and has a space smaller than that of the first opening (11A), and
the gas is supplied to the second opening (13B) through a second throttle portion (30B) that is formed between two parts, extends in a direction perpendicular to the central axis of (Zr) rotation of the shaft (4), and has a space smaller than that of the second opening (11B).

8. The rotating mechanism (1) according to claim 7, wherein a first spacer (31A) is provided between the two parts that form the first throttle portion (30A), and a second spacer (31B) is provided between the two parts that form the second throttle portion (30B).

9. A machine tool comprising the rotating mechanism (1) according to any one of claims 1 to 8.

10. A semiconductor manufacturing device comprising the rotating mechanism (1) according to any one of claims 1 to 8.

## Patentansprüche

1. Drehmechanismus (1), der Folgendes umfasst:
ein Gehäuse (2);
eine Welle (4), die in eine erste Bohrung (2HA) und eine zweite Bohrung (2HB), die im Gehäuse (2) vorgesehen sind, eingeführt ist;
ein Lager (7A, 7B, 7C), das im Gehäuse (2) vorgesehen ist und die Welle drehbar trägt (4);
ein erstes Drehelement (5A), das auf einem ersten Endabschnitt (4TA) der Welle (4) vorgesehen ist, um sich mit der Welle (4) zu drehen, und einen vorstehenden Abschnitt (5FA) umfasst, der aus der ersten Bohrung (2HA) in ihrer radialen Richtung und zu einem Seitenteil des Gehäuses (2) vorsteht, wobei eine Innenumfangsfläche (5WI) des vorstehenden Abschnitts (5FA) einer Außenumfangsoberfläche des Seitenteil (2FRAS) des Gehäuses (2) gegenüberliegt und dazwischen ein erster Spalt (13A) mit einer vorgegebenen Größe (tsa) vorhanden ist;
ein zweites Drehelement (5B), das auf einem zweiten Endabschnitt (4TB) der Welle (4) vorgesehen ist, um sich mit der Welle (4) zu drehen, aus der zweiten Bohrung (2HB) in ihrer radialen Richtung vorsteht und dem Gehäuse (2) auf der Seite des zweiten Endabschnitts (4TB) gegenüberliegt, wobei dazwischen ein zweiter Spalt (13B) mit einer vorgegebenen Größe (tsb) vorhanden ist;
eine erste Öffnung (11A), die zur Außenseite der ersten Bohrung (2HA) des Gehäuses (2) in ihrer radialen Richtung offen ist, um dem ersten Drehelement (5A) gegenüberzuliegen, und sich in einer Umfangsrichtung der ersten Bohrung (2HA) zum Zuführen eines Gases in den ersten Spalt (13A) erstreckt; und
eine zweite Öffnung (11B), die zur Außenseite der zweiten Bohrung (2HB) des Gehäuses (2) in ihrer radialen Richtung offen ist, um dem zweiten Drehelement (5B) gegenüberzuliegen, und sich in einer Umfangsrichtung der zweiten Bohrung (2HB) zum Zuführen eines Gases in den zweiten Spalt (13B) erstreckt.

2. Drehmechanismus (1) nach Anspruch 1, wobei das erste Drehelement (5A) über dem zweiten Drehelement (5B) angeordnet ist.

3. Drehmechanismus (1) nach Anspruch 1 oder 2, wobei eine Größe des ersten Spalts (13A) größer als eine Ausdehnung der ersten Öffnung (11A) in einer radialen Richtung der Welle (4) ist und eine Größe des zweiten Spalts (13B) größer als eine Ausdehnung der zweiten Öffnung (11B) in der radialen Richtung der Welle (4) ist.

4. Drehmechanismus (1) nach einem der Ansprüche 1 bis 3, wobei ein Abschnitt zwischen dem ersten Drehelement (5Ab) und dem Gehäuse (2b) in einem Abschnitt zwischen der ersten Bohrung (2HA) und der ersten Öffnung (11A) einen Abschnitt umfasst, dessen Größe (tc) kleiner als eine Ausdehnung (ta) der ersten Öffnung (11A) in einer radialen Richtung der ersten Bohrung (2HA) ist und ein Abschnitt zwischen dem zweiten Drehelement (5Bb) und dem Gehäuse (2b) in einem Abschnitt zwischen der zweiten Bohrung (2HB) und der zweiten Öffnung (11B) einen Abschnitt umfasst, dessen Größe (td) kleiner als eine Ausdehnung (tb) der zweiten Öffnung (11B) in einer radialen Richtung der zweiten Bohrung (2HB) ist.

5. Drehmechanismus (1) nach einem der Ansprüche 1 bis 4, der eine Nut (16) in der Umfangsrichtung der ersten Bohrung (2HA) in einem Abschnitt des Gehäuses (2) neben dem ersten Spalt (13A) umfasst.

6. Drehmechanismus (1) nach einem der Ansprüche 1 bis 5, der eine Nut (17) in der Umfangsrichtung der zweiten Bohrung (2HB) in einem Abschnitt des zweiten Drehelements (5Be) neben dem zweiten Spalt (13B) umfasst.

7. Drehmechanismus (1) nach einem der Ansprüche 1 bis 6, wobei
das Gas der ersten Öffnung (13A) durch einen ersten Drosselabschnitt (30A) zugeführt wird, der zwischen zwei Teilen ausgebildet ist, sich in einer Richtung senkrecht zu einer Mittelachse (Zr) der Drehung der Welle (4) erstreckt und einen kleineren Raum als den der ersten Öffnung (11A) hat, und
das Gas der zweiten Öffnung (13B) durch einen zweiten Drosselabschnitt (30B) zugeführt wird, der zwischen zwei Teilen ausgebildet ist, sich in einer Richtung senkrecht zu der Mittelachse (Zr) der Drehung der Welle (4) erstreckt und einen kleineren Raum als den der zweiten Öffnung (11B) hat.

8. Drehmechanismus (1) nach Anspruch 7, wobei ein erster Abstandshalter (31A) zwischen den beiden Teilen, die den ersten Drosselabschnitt (30A) bilden, vorgesehen ist und ein zweiter Abstandshalter (31B) zwischen den beiden Teilen, die den zweiten Drosselabschnitt (30B) bilden, vorgesehen ist.

9. Werkzeugmaschine, die den Drehmechanismus (1) nach einem der Ansprüche 1 bis 8 umfasst.

10. Halbleiterherstellungsvorrichtung, die den Drehmechanismus (1) nach einem der Ansprüche 1 bis 8 umfasst.

## Revendications

1. Mécanisme rotatif (1) comprenant :
un boîtier (2) ;
un arbre (4) qui est inséré dans un premier trou (2HA) et un second trou (2HB) prévus dans le boîtier (2) ;
un palier (7A, 7B, 7C) qui est prévu dans le boîtier (2) et supporte l'arbre (4) de manière rotative ;
un premier élément rotatif (5A) qui est prévu sur une première section d'extrémité (4TA) de l'arbre (4) de manière à tourner avec l'arbre (4) et comporte une section saillante (5FA) qui fait saillie en dehors du premier trou (2HA) dans sa direction radiale et vers une section latérale du boîtier (2), une surface circonférentielle intérieure (5WI) de la section saillante (5FA) se trouvant à l'opposé d'une surface circonférentielle extérieure de la section latérale (2FRAS) du boîtier (2) de part et d'autre d'un premier espace (13A) d'une taille prédéterminée (tsa) ;
un second élément rotatif (5B) qui est prévu sur une seconde section d'extrémité (4TA) de l'arbre (4) de manière à tourner avec l'arbre (4), fait saillie en dehors du second trou (2HB) dans sa direction radiale et se trouve à l'opposé du boîtier (2) du côté de la seconde section d'extrémité (4TB) de l'autre côté d'un second espace (13B) d'une taille prédéterminée (tsb) ;
une première ouverture (11A) qui s'ouvre sur l'extérieur du premier trou (2HA) du boîtier (2) dans sa direction radiale de manière à se trouver à l'opposé du premier élément rotatif (5A) et s'étend dans une direction circonférentielle du premier trou (2HA) pour approvisionner le premier espace (13A) en gaz ; et
une seconde ouverture (11B) qui s'ouvre sur l'extérieur du second trou (2HB) du boîtier (2) dans sa direction radiale de manière à se trouver à l'opposé du second élément rotatif (5B) et s'étend dans une direction circonférentielle du second trou (2HB) pour approvisionner le second espace (13B) en gaz.

2. Mécanisme rotatif (1) selon la revendication 1, où le premier élément rotatif (5A) est disposé au-dessus du second élément rotatif (5B).

3. Mécanisme rotatif (1) selon la revendication 1 ou 2, où une taille du premier espace (13A) est plus grande qu'une dimension de la première ouverture (11A) dans une direction radiale de l'arbre (4), et une taille du second espace (13B) est plus grande qu'une dimension de la seconde ouverture (11B) dans la direction radiale de l'arbre (4).

4. Mécanisme rotatif (1) selon l'une quelconque des revendications 1 à 3, où une section entre le premier élément rotatif (5Ab) et le boîtier (2b) dans une section entre le premier trou (2HA) et la première ouverture (11A) comporte une section dont la taille (tc) est plus petite qu'une dimension (ta) de la première ouverture (11A) dans une direction radiale du premier trou (2HA), et une section entre le second élément rotatif (5Bb) et le boîtier (2b) dans une section entre le second trou (2HB) et la seconde ouverture (11B) comporte une section dont la taille (td) est plus petite qu'une dimension (tb) de la seconde ouverture (11B) dans une direction radiale du second trou (2HB).

5. Mécanisme rotatif (1) selon l'une quelconque des revendications 1 à 4, comprenant une rainure (16) dans la direction circonférentielle du premier trou (2HA) dans une section du boîtier (2) adjacente au premier espace (13A).

6. Mécanisme rotatif (1) selon l'une quelconque des revendications 1 à 5, comprenant une rainure (17) dans la direction circonférentielle du second trou (2HB) dans une section du second élément rotatif (5Be) adjacente au second espace (13B).

7. Mécanisme rotatif (1) selon l'une quelconque des revendications 1 à 6, où
la première ouverture (13A) est approvisionnée en gaz à travers une première section d'étranglement (30A) qui est formée entre deux parties, s'étend dans une direction perpendiculaire à un axe central (Zr) de rotation de l'arbre (4) et présente un espace plus petit que celui de la première ouverture (11A), et
la seconde ouverture (13B) est approvisionnée en gaz à travers une seconde section d'étranglement (30B) qui est formée entre deux parties, s'étend dans une direction perpendiculaire à un axe central (Zr) de rotation de l'arbre (4) et présente un espace plus petit que celui de la seconde ouverture (11B).

8. Mécanisme rotatif (1) selon la revendication 7, où une première entretoise (31A) est prévue entre les deux parties qui forment la première section d'étranglement (30A) et une seconde entretoise (31B) est prévue entre les deux parties qui forment la seconde section d'étranglement (30B).

9. Machine-outil comprenant le mécanisme rotatif (1) selon l'une quelconque des revendications 1 à 8.

10. Dispositif de fabrication de semi-conducteurs comprenant le mécanisme rotatif (1) selon l'une quelconque des revendications 1 à 8.
